# EUROPÄISCHE PATENTSCHRIFT

(11) **EP 3 546 974 B1**
(45) Veröffentlichungstag und Bekanntmachung des Hinweises auf die Patenterteilung: **01.12.2021**
(21) Anmeldenummer: 18164022.8
(22) Anmeldetag: 26.03.2018
(51) Int. Cl.: G01R 33/565, G01R 33/24

(54) **VERFAHREN UND VORRICHTUNG ZUR KORREKTUR EINER B0-INHOMOGENITÄT MITTELS EINES HOCHFREQUENZSIGNALS**
METHOD AND DEVICE FOR CORRECTING B0 INHOMOGENEITY BY MEANS OF A HIGH FREQUENCY SIGNAL
PROCÉDÉ ET DISPOSITIF DE CORRECTION DE L'INHOMOGÉNÉITÉ B0 AU MOYEN D'UN SIGNAL HAUTE FRÉQUENCE

(43) Veröffentlichungstag der Anmeldung: 02.10.2019
(73) Patentinhaber: Siemens Healthcare GmbH, 91052 Erlangen (DE)
(72) Erfinder: Gebhardt, Matthias, 91052 Erlangen (DE); Kartäusch, Ralf, 91058 Erlangen (DE); Vester, Markus, 90471 Nürnberg (DE)

(56) Entgegenhaltungen:
- HU Y. ET AL.: "Independent band-specific correction for B0 and B1 inhomogeneities in multiband 2D RF pulses", INTERNATIONAL SOCIETY FOR MAGNETIC RESONANCE IN MEDICINE, 25TH ANNUAL MEETING & EXHIBITION, Nr. 3852, 7. April 2017 (2017-04-07), XP040691420, Honolulu, HI, USA
- KARTÄUSCH R. ET AL.: "Spatial phase encoding using a Bloch-Siegert Shift gradient", PROCEEDINGS OF THE INTERNATIONAL SOCIETY FOR MAGNETIC RESONANCE IN MEDICINE, 21ST ANNUAL MEETING & EXHIBITION, 7. April 2013 (2013-04-07), Seite 0371, XP040627970, Utah, USA

## Beschreibung

Die Erfindung betrifft ein Verfahren zur B0-Feldkorrektur bei einem Magnetresonanztomographen.

Magnetresonanztomographen sind bildgebende Vorrichtungen, die zur Abbildung eines Untersuchungsobjektes Kernspins des Untersuchungsobjektes mit einem starken äußeren Magnetfeld ausrichten und durch ein magnetisches Wechselfeld zur Präzession um diese Ausrichtung anregen. Die Präzession bzw. Rückkehr der Spins aus diesem angeregten in einen Zustand mit geringerer Energie wiederum erzeugt als Antwort ein magnetisches Wechselfeld, auch als Magnetresonanzsignal bezeichnet, das über Antennen empfangen wird.

Mit Hilfe von magnetischen Gradientenfeldern wird den Signalen eine Ortskodierung aufgeprägt, die nachfolgend eine Zuordnung von dem empfangenen Signal zu einem Volumenelement ermöglicht. Das empfangene Signal wird dann ausgewertet und eine dreidimensionale bildgebende Darstellung des Untersuchungsobjektes bereitgestellt. Die erzeugte Darstellung gibt eine räumliche Dichteverteilung der Spins an.

Die Qualität der Magnetresonanztomographie ist wesentlich von der Homogenität des statischen B0-Magnetfeldes zur Ausrichtung der Kernspins abhängig. Inhomogenitäten verursachen dabei sowohl räumliche Verzerrungen des erzeugten Bildes, da die Ortskodierung durch Gradientenfelder auch von der Magnetfeldstärke abhängt. Auch die Bildkontraste werden von B0-Feldinhomogenitäten beeinflusst, denn die Stärke der Anregung geht bei Abweichung der Larmorfrequenz von der Sendefrequenz eines Anregungspulses ebenfalls zurück. Nicht zuletzt können nahe beieinanderliegende Larmorfrequenzen nicht mehr korrekt getrennt werden und Fett erscheint beispielsweise als freies Gewebewasser.

BO-Inhomogenitäten können beispielsweise von dem Feldmagneten selbst, Materialien des Magnetresonanztomographen oder von der Umgebung verursacht werden. Diese Störungen sind meist statisch und können beispielsweise durch Ferromagnetika korrigiert werden.

Zur Korrektur temporärer Feldveränderungen sind auch Shim-Spulen bekannt, die von einem konstanten, einstellbaren Strom durchflossen werden.

Es werden jedoch auch innerhalb des Patienten durch unterschiedliche magnetische Suszeptibilität des Gewebes Inhomogenitäten im statischen B0-Feld verursacht. Diese lassen sich aufgrund der Lage im Körper und aufgrund der grundsätzlichen Eigenschaften der Magnetfelder nur bedingt oder gar nicht durch externe statische Magnetspulen korrigieren. Gerade wenn die Homogenität des durch Gewebesuszeptibilität gestörten B0-Feldes nicht nur in einer zweidimensionalen Schicht, sondern in einem ganzen dreidimensionalen Volumen erzielt werden soll, sind die Möglichkeiten mithilfe externer mit statischen Strömen betriebener Feldspulen begrenzt.

Aus dem Dokument HU Y. ET AL.: "Independent band-specific correction for B0 and B1 inhomogeneities in multiband 2D RF pulses 11 (INTERNATIONAL SOCIETY FOR MAGNETIC RESONANCE IN MEDICINE, 25TH ANNUAL MEETING & EXHIBITION, Nr. 3852, 7. April 2017 (2017-04-07), XP040691420, Honolulu, HI, USA) ist ein Verfahren bekannt, B0 und B1 Inhomogenitäten zu korrigieren, indem Mittenfrequenz und Amplitude für jedes Frequenzband unabhängig voneinander angepasst werden.

Die Veröffentlichung Spatial phase encoding using a Bloch-Siegert Shift gradient von Ralf Kartäusch, Florian Fidler, Toni Drießle, Thomas Kampf, Thomas C. Basse-Lüscbrink und and Xavier Helluy (Proc. Intl. Soc. Mag. Reson. Med. 21 (2013)) offenbart ein Verfahren zur Phasenkodierung mittels RF-Pulsen unter Anwendung des Bloch-Siegert-Effektes.

Es ist daher eine Aufgabe der vorliegenden Erfindung, eine Vorrichtung und ein Verfahren zur Verbesserung der Bilderfassung bei Magnetfeldinhomogenitäten bereitzustellen.

Die Aufgabe wird durch ein erfindungsgemäßes Verfahren nach Anspruch 1 und einen erfindungsgemässen Magnetresonanztomographen nach Anspruch 9 gelöst.

Das erfindungsgemäße Verfahren wird auf einem erfindungsgemäßen Magnetresonanztomographen ausgeführt, der eine Steuereinheit, eine Hochfrequenzeinheit und eine Sendeantenne aufweist. In einem Schritt wird ein Sendesignal durch die Steuereinheit ermittelt, das zur Korrektur der Auswirkung der Inhomogenität des statischen B0-Magnetfeldes in einem Untersuchungsvolumen mittels des Bloch-Siegert-Effektes geeignet ist. Als Korrektur der Auswirkung wird insbesondere eine Korrektur bzw. Verschiebung der Larmorfrequenz verstanden.

Aus dem Bloch-Siegert-Effekt ist bekannt, dass eine Larmorfrequenz, hier gegeben durch das statische magnetische B0-Feld eines Feldmagneten des Magnetresonanztomographen an dem Ort des Kernspins und dem magnetischen Moment des Kernspins, durch ein magnetisches Wechselfeld an diesem Ort mit einer Frequenz ungleich dieser lokalen Larmorfrequenz im Frequenzraum verschoben werden kann. Dabei ist die Frequenzverschiebung proportional zum Quadrat der Feldstärke des Wechselfeldes und indirekt proportional zur Differenz der Frequenzen des Korrektursignals und der lokalen Larmorfrequenz. So kann aus einer B0-Abweichung an einem gegebenen Ort eine zu erzielende Feldstärke in Abhängigkeit von der Frequenz des Korrektursignals errechnet werden, mit der die Larmorfrequenz auf die bzw. in Richtung der idealen Larmorfrequenz ohne B0-Inhomogenität verschoben werden kann. Auf diese Weise kann auch eine zu erzielende räumliche Feldstärke- bzw. LeistungsVerteilung über das Untersuchungsgebiet bestimmt werden. Die BO-Inhomogenität kann beispielsweise durch Erfahrungswerte, z.B. aus der Physiologie des Patienten im Untersuchungsbereich abgeschätzt und als Tabelle im Magnetresonanztomographen gespeichert sein oder auch durch eine nachfolgend erläuterte B0-Feldmessung mit dem Magnetresonanztomographen bestimmt werden. Auch ist es denkbar, dass beispielsweise durch eine mehrkanalige Hochfrequenzeinheit unterschiedliche Signalanteile mit unterschiedlichen Frequenzen erzeugt. Es ist aber auch denkbar, dass lediglich für eine vorgegebene Feldverteilung einer Sendeantenne, beispielsweise einer Körperspule oder einer Lokalspule, eine Frequenz und eine Amplitude bzw. Leistung des Sendesignals bestimmt wird, die lediglich an einem ausgewählten Ort im Untersuchungsvolumen die Auswirkung der BO-Inhomogenität korrigiert. Als Korrektur wird es dabei verstanden, wenn die Auswirkungen der BO-Inhomogenität auf die Magnetresonanzmessung wesentlich reduziert werden, beispielsweise nur noch einer Abweichung um weniger als 50%, 25% oder 10% der Abweichung durch die tatsächliche B0-Inhomogenität entsprechen.

In einem weiteren Schritt des Verfahrens wird das ermittelte Sendesignal mit der Hochfrequenzeinheit erzeugt und über die Antenne in das Untersuchungsvolumen ausgesendet. Vorzugsweise handelt es sich bei der Antenne und der Hochfrequenzeinheit um die vorhandenen Hochfrequenzsender für die Anregungspulse und Sendeantennen wie Körperspule oder eine lokale Sendespule. Es sind aber auch separate Sender und Antennen denkbar, beispielsweise wenn die B0-Inhomogenität auch beim Anregungspuls durch ein Korrektur-Wechselfeld kompensiert werden sollte. Vorzugsweise ermöglicht es dabei die Antenne allein oder in Verbindung mit der Hochfrequenzeinheit, eine steuerbare räumliche Feldstärkeverteilung zu erzielen, wie beispielhaft noch an einer Ausführungsform in den Unteransprüchen ausgeführt wird. In Verbindung mit einer mehrkanaligen Hochfrequenzeinheit ist es auch denkbar, dass auch die Frequenz des erzeugten magnetischen Wechselfeldes räumlich variiert wird.

Das erfindungsgemäße Verfahren ermöglicht auf vorteilhafte Weise eine flexible Korrektur von BO-Inhomogenitäten, insbesondere auch, wenn diese durch Suszeptibilitätsvariationen verursacht werden, deren Magnetisierung nicht rotationsfrei ist und daher durch herkömmliche externe Spulen wenigstens in einem dreidimensionalen Volumen nicht kompensiert werden kann.

Der erfindungsgemäße Magnetresonanztomograph teilt die Vorteile des von ihm ausgeführten Verfahrens.

Weitere vorteilhafte Ausführungsformen sind in den Unteransprüchen angegeben.

In einer möglichen Ausführungsform des erfindungsgemäßen Verfahrens weist der Schritt des Ermittelns des Sendesignales weiterhin den Schritt auf, eine BO-Inhomogenität in dem Untersuchungsvolumen durch den Magnetresonanztomographen zu bestimmen. Das kann beispielsweise wie nachfolgend zu einem anderen Unteranspruch beschrieben, durch das Erfassen bzw. Messen einer BO-Map bzw. Karte erfolgen. Es ist aber beispielsweise auch denkbar, dass aufgrund der Position und Physiologie unter Verwendung von gespeicherten Informationen eine B0-Inhomogenität von der Steuereinheit abgeschätzt wird. Es könnte z.B. eine generalisierte B0-Karte für einen menschlichen Körper gespeichert sein, die nur mittels weniger Parameter wie Lage, Größe, Gewicht und Umfang skaliert wird, um die BO-Inhomogenität abzuschätzen.

Weiterhin weist der Schritt des Ermittelns des Sendesignales den Schritt des Bestimmens einer Frequenz und einer räumlichen Verteilung des Sendesignales durch die Steuereinheit auf. Wie bereits beschrieben, ist die Verschiebung der Larmorfrequenz durch den Bloch-Siegert-Effekt proportional zu dem Quadrat der Feldstärke des von dem Sendesignal erzeugten magnetischen Wechselfeldes und indirekt proportional zur Differenz der lokalen Larmorfrequenz zu der Frequenz des Sendesignals. Die Steuereinheit ermittelt mit dieser Gleichung ein Sendesignal, dass den Effekt der Inhomogenität des B0-Feldes zumindest teilweise kompensiert. Mit anderen Worten, bei Aussendung des Sendesignals über die Antenne wird an mindestens einem Ort des Untersuchungsvolumens die Frequenz, mit der die Kernspins präzedieren, in Richtung der Larmorfrequenz für den B0-Wert für das ideale homogene B0-Feld verschoben, sodass die Frequenzdifferenz beispielsweise um mehr als 50%, 80%, oder 90% reduziert wird. Vorzugsweise erfolgt die Korrektur an mehreren Orten. Es ist beispielsweise auch denkbar, dass mit einem Optimierungsverfahren die quadratische Abweichung minimiert wird, indem Amplitude und/oder Frequenz des Sendesignals als Parameter variiert werden. Wie nachfolgend beschrieben, kann diese Amplitude und Frequenz auch ortsabhängig variiert werden.

Das erfindungsgemäße Verfahren erlaubt es so auf vorteilhafte Weise, die Korrektur der BO-Inhomogenitäten an den Patienten anzupassen.
Bei einer denkbaren Ausführungsform des erfindungsgemäßen Verfahrens wird dieses auf einem Magnetresonanztomographen ausgeführt, dessen Sendeantenne eine Mehrzahl an Antennenelementen aufweist. Diese Sendeantenne kann beispielweise eine Körperspule mit mehreren unabhängig ansteuerbaren Segmenten sein oder auch eine lokale Sendespulenmatrix. Denkbar ist auch eine separate Antenne mit einem Antennenarray für das Sendesignal. Bei der Ausführungsform des erfindungsgemäßen Verfahrens weist der Schritt des Aussendens einen Schritt auf, eine Konfiguration der Hochfrequenzeinheit und/oder der Antennenelementen zur näherungsweisen Erzielung der gewünschten räumlichen Verteilung zu bestimmen. Es ist beispielsweise möglich, dass die Hochfrequenzeinheit mehrere unabhängige Kanäle, auch als pTX bezeichnet, aufweist. Die Kanäle speisen dann unterschiedliche Antennenelemente. Über die Phasenlage - bei gleicher Frequenz - und die Amplitudenverhältnisse kann dann die räumliche Verteilung des Sendesignals und die davon erzeugte Feldstärke an unterschiedlichen Orten gesteuert werden. Es kann aber auch durch steuerbare Phasenverschiebungselemente in der Hochfrequenzeinheit oder der Sendeantenne aus einem einzigen Hochfrequenzsignal mittels mehrerer Antennenelemente eine gesteuerte Richtwirkung erzielt werden.

Es ist aber auch denkbar, dass die Frequenzen der Ausgänge der Kanäle unterschiedlich sind, sodass die räumliche Verteilung nur über die Amplitude und die Auswahl der angesteuerten Antennenelemente mit deren Sendecharakteristik abhängt.

Für alle diese Fälle lässt sich mit den Gesetzen der Elektrodynamik, wie schon bei der Anregung mittels pTX, eine Konfiguration für die Hochfrequenzeinheit und/oder Sendeantenne bestimmen, die die gewünschte Amplituden- und gegebenen Falls Frequenzverteilung erzeugt. In einem weiteren Schritt des erfindungsgemäßen Verfahrens wird die Hochfrequenzeinheit und/oder Sendeantenne gemäß der Konfiguration eingestellt.

Schließlich wird in einem weiteren Schritt das ermittelte Sendesignal mit der Hochfrequenzeinheit erzeugt und über die Sendeantenne in das Untersuchungsvolumen ausgesendet. Die Konfiguration der Hochfrequenzeinheit und/oder der Sendeantenne sorgt dabei dafür, dass die gewünschte räumliche Verteilung erzielt wird.

Auf vorteilhafte Weise ermöglicht die Mehrzahl der Antennenelemente der Sendeantenne eine genauere und flexiblere Steuerung der Korrektur.

In einer möglichen Ausführungsform des erfindungsgemäßen Verfahrens weist das Verfahren weiterhin den Schritt auf, eine BO-Map mittels des Magnetresonanztomographen zu ermitteln. Die kann zum Beispiel erfolgen, indem Magnetresonanzsignale zu unterschiedlichen Echozeiten erfasst werden und daraus erzeugte Abbildungen verglichen werden. Auch andere Verfahren zur Messung sind bekannt.

Bei der Ausführungsform des erfindungsgemäßen Verfahrens wird dann beim Ermitteln einer B0-Inhomogenität in dem Untersuchungsvolumen durch den Magnetresonanztomographen die erfasste B0-Map verwendet, indem beispielsweise Abweichung von einem konstanten Soll-B0-Wert aus der B0-Map bestimmt werden.

Die so ermittelte B0-Map gibt die tatsächlichen B0-Inhomogenitäten im Untersuchungsvolumen wieder, vorzugsweise unter Anwesenheit des realen Patienten. Es ist auch denkbar, dass die B0-Map unter Anwendung des erfindungsgemäßen Verfahrens, d.h. mit einem Hochfrequenz-Korrektursignal bestimmt wird und so auch die Wirkung der Korrektur erfasst oder iterativ verbessert werden kann. Die BO-Inhomogenitäten werden so genauer bestimmt und die Korrektur kann mit dem Verfahren auf vorteilhafte Weise auch genauer erfolgen.

In einer denkbaren Ausführungsform des erfindungsgemäßen Verfahrens erfolgt das Ermitteln einer B0-Map mittels des Magnetresonanztomographen iterativ unter Anwendung einer Korrektur nach dem erfindungsgemäßen Verfahren. Dabei ist es beispielsweise denkbar, dass als Startwert für die B0-Inhomogenitäten ein konstantes, ideales BO-Feld angenommen wird, ohne Inhomogenitäten. Bei dem Start der Iteration der Messung wird dann zunächst kein Sendesignal zur Korrektur der Larmorfrequenz ausgegeben. Unter diesen Bedingungen wird nach den bekannten Verfahren eine erste (reale) BO-Map von dem Magnetresonanztomographen gemessen, die Grundlage zur Bestimmung eines Sendesignals zur Korrektur der Larmorfrequenz gemäß dem erfindungsgemäßen Verfahren ist.

Unter Anwendung dieses Sendesignals wird eine zweite BO-Map erfasst, aus der noch nicht durch das Sendesignal korrigierte Inhomogenitäten bestimmt werden, die wiederum zum Ermitteln eines zweiten Sendesignals gemäß dem erfindungsgemäßen Verfahren ist. Dies wird iterativ wiederholt, wobei immer die BO-Map aus der Iteration n-1 Grundlage zur Bestimmung des n-ten Sendesignals ist.

Ein Abbruch kann beispielsweise erfolgen, wenn die gemessenen BO-Inhomogenitäten kleiner als ein vorbestimmter Abbruchwert sind, sich die Inhomogenitäten im Nachfolgenden Schritt nicht mehr verringern oder eine maximale Anzahl an Iterationen erreicht ist.

In einer möglichen Ausführungsform des erfindungsgemäßen Verfahrens weist das Verfahren weiterhin den Schritt auf, eine Frequenzverteilung und Leistung eines Anregungspulses zu bestimmen, der unter der bestimmten B0-Inhomogenität eine homogene Anregung in dem Untersuchungsvolumen erzielt. Aufgrund der starken Anregungspulse kann es beispielsweise aus Gründen der SAR-Belastung, aber auch wegen erforderlicher sehr hoher Werte für die Amplitude des Sendesignals zur Korrektur oder nicht zuletzt wegen Nutzung der gleichen Hochfrequenzeinheit und/oder Antenne erforderlich sein, bei der Anregung der Kernspins B0-Inhomogenitäten auf andere Weise auszugleichen. Dies kann beispielsweise durch einen breitbandigen Anregungspuls erfolgen, der Kernspins mit unterschiedlicher Larmorfrequenz anregen kann. Die Form des Pulses kann bei bekannter B0-Verteilung beispielsweise mittels diskreter Fourier Transformation bestimmt werden. In einem Schritt des Verfahrens wird dieser Anregungspuls dann von der Hochfrequenzeinheit erzeugt und über eine Anregungsantenne ausgesendet. Dies kann beispielsweise die Körperspule oder auch eine lokale Sendespule sein.

Durch einen breitbandigen Anregungspuls kann vorteilhafter Weise eine Anregung aller Kernspins erfolgen, ohne durch ein zusätzliches Korrektursignal die SAR-Belastung weiter zu erhöhen.

In einer denkbaren Ausführungsform des erfindungsgemäßen Verfahrens erfolgt der Schritt des Aussendens während der Phasencodierung und/oder des Readouts. Insbesondere während der Phasenkodierung werden in den meisten Untersuchungsverfahren eines Magnetresonanztomographen keine Hochfrequenzsignale in das Untersuchungsvolumen emittiert oder daraus empfangen. So ist es möglich, ohne störende Wechselwirkungen das Sendesignal zur Korrektur auszusenden. Vorzugsweise kann dies dabei mit der gleichen Hochfrequenzeinheit und Sendeantenne wie bei dem Anregungspuls erfolgen. Während des Readouts, d.h. der Phase einer Magnetresonanzmessung, während derer die Magnetresonanzsignale empfangen und aufgezeichnet werden, ist es dabei erforderlich, Störungen durch das Sendesignal zur Korrektur zu vermeiden. Die kann beispielsweise durch eine geeignete Wahl der Frequenz des Sendesignals zur Korrektur unter Verwendung von Filtern auf der Empfangsseite erreicht werden. Denkbar wäre auch ein intermittierendes Senden/Empfangen.

Insgesamt ist es vorzuziehen, wenn das Sendesignal zur Korrektur über eine möglichst lange Zeit eines Pulse-Trains ausgesendet wird. So kann auf vorteilhafte Weise der Betrag der Korrektur und damit der Feldstärke bzw. Leistung reduziert werden.

In einer möglichen Ausführungsform des erfindungsgemäßen Verfahrens wird in einem Schritt des Ermittelns des Sendesignals eine zeitliche Abhängigkeit der Frequenz und/oder Amplitude derart bestimmt, dass durch das ausgesendete Sendesignal über die Dauer der Magnetresonanzmessung die Larmorfrequenz im zeitlichen Mittel im Wesentlichen korrigiert wird. Mittels des Bloch-Siegert-Effektes ist es auch denkbar, die Frequenz, mit der der Kernspin präzediert, auch über die Larmorfrequenz bei dem idealen B0 hinaus zu ziehen bzw. überkompensieren. Dies erlaubt es, ein Sendesignal mit zeitlicher Modulation der Frequenz und/oder Amplitude derart zu bestimmen und dann auch auszusenden, dass im zeitlichen Mittel ein Zeitabschnitt ohne Sendesignal durch einen Zeitabschnitt mit Überkompensation ausgeglichen wird.

Auf diese Weise kann beispielsweise bei einem Readout das Senden eingestellt werden, um den Empfang des MR-Signals nicht zu stören, und auf vorteilhafte Weise die Abweichung anschließend durch Überkompensation ausgeglichen werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.

Es zeigen:
- Fig. 1: eine beispielhafte schematische Darstellung eines Magnetresonanztomographen mit einer erfindungsgemäßen Hochfrequenzeinheit;
- Fig. 2: eine beispielhafte schematische Darstellung einer Hochfrequenzeinheit und Lokalspule zur Ausführung des erfindungsgemäßen Verfahrens;
- Fig. 3: einen beispielhaften zeitlichen Ablauf einer Magnetresonanzmessung mit dem erfindungsgemäßen Verfahren;
- Fig. 4: ein schematischer Ablaufplan eines erfindungsgemäßen Verfahrens.

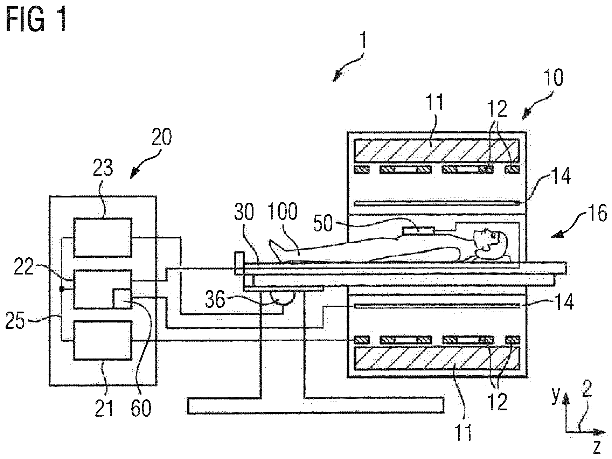

Fig. 1 zeigt eine schematische Darstellung einer Ausführungsform eines erfindungsgemäßen Magnetresonanztomographen 1.

Die Magneteinheit 10 weist einen Feldmagneten 11 auf, der ein statisches Magnetfeld B0 zur Ausrichtung von Kernspins von Proben bzw. Patienten 100 in einem Aufnahmebereich erzeugt. Der Aufnahmebereich ist in einem Patiententunnel 16 angeordnet, der sich in einer Längsrichtung 2 durch die Magneteinheit 10 erstreckt. Ein Patient 100 ist mittels der Patientenliege 30 und der Verfahreinheit 36 der Patientenliege 30 in den Aufnahmebereich verfahrbar. Üblicherweise handelt es sich bei dem Feldmagneten 11 um einen supraleitenden Magneten, der magnetische Felder mit einer magnetischen Flussdichte von bis zu 3T, bei neuesten Geräten sogar darüber, bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Untersuchungsvolumen dem Magnetfeld B0 variable Magnetfelder in drei Raumrichtungen zu überlagern. Die Gradientenspulen 12 sind üblicherweise Spulen aus normalleitenden Drähten, die zueinander orthogonale Felder in dem Untersuchungsvolumen erzeugen können.

Die Magneteinheit 10 weist ebenfalls eine Körperspule 14 auf, die dazu ausgelegt ist, ein über eine Signalleitung 33 zugeführtes Hochfrequenzsignal in das Untersuchungsvolumen abzustrahlen und von dem Patient 100 emittierte Resonanzsignale zu empfangen und über eine Signalleitung abzugeben. Bevorzugter Weise wird aber die Körperspule 14 für das Aussenden des Hochfrequenzsignals und/oder das Empfangen durch Lokalspulen 50 ersetzt, die in dem Patiententunnel 16 nahe am Patient 100 angeordnet sind. Es ist aber auch denkbar, dass die Lokalspule 50 zum Senden und Empfangen ausgelegt ist und deshalb eine Körperspule 14 entfallen kann.

Eine Steuereinheit 20 versorgt die Magneteinheit 10 mit den verschiedenen Signalen für die Gradientenspulen 12 und die Körperspule 14 und wertet die empfangenen Signale aus. Eine Magnetresonanztomographen-Steuerung 23 koordiniert dabei die Untereinheiten.

So weist die Steuereinheit 20 eine Gradientenansteuerung 21 auf, die dazu ausgelegt ist, die Gradientenspulen 12 über Zuleitungen mit variablen Strömen zu versorgen, welche zeitlich koordiniert die erwünschten Gradientenfelder in dem Untersuchungsvolumen bereitstellen.

Weiterhin weist die Steuereinheit 20 eine Hochfrequenzeinheit 22 auf, die ausgelegt ist, einen Hochfrequenz-Puls mit einem vorgegebenen zeitlichen Verlauf, Amplitude und spektraler Leistungsverteilung zur Anregung einer Magnetresonanz der Kernspins in dem Patienten 100 zu erzeugen. Dabei können Pulsleistungen im Bereich von Kilowatt erreicht werden. Die einzelnen Einheiten sind über einen Signalbus 25 untereinander verbunden.

Das von Hochfrequenzeinheit 22 erzeugte Hochfrequenzsignal wird über eine Signalverbindung der Körperspule 14 zugeführt und in den Körper des Patienten 100 ausgesendet, um dort die Kernspins anzuregen. Denkbar ist aber auch ein Aussenden des Hochfrequenzsignals über eine oder mehrere Spulenwicklungen der Lokalspulenmatrix 50.

Es ist aber nach dem erfindungsgemäßen Verfahren denkbar, die Hochfrequenzeinheit 22 und die Körperspule 14 und/oder die Lokalspule 50 zur Korrektur der Larmorfrequenz einzusetzen.

Die Lokalspulenmatrix 50 empfängt dann vorzugsweise ein Magnetresonanzsignal aus dem Körper des Patienten 100, denn aufgrund des geringen Abstandes ist das Signal-zu-Rauschverhältnis (SNR) der Lokalspule 50 besser als bei einem Empfang durch die Körperspule 14. Das von der Lokalspulenmatrix 50 empfangene MR-Signal wird in der Lokalspule 50 aufbereitet und an die Hochfrequenzeinheit 22 des Magnetresonanztomographen 1 zur Auswertung und Bilderfassung weitergeleitet. Vorzugsweise wird dazu die Signalverbindung 33 genutzt, es ist aber beispielsweise auch eine drahtlose Übertragung denkbar.

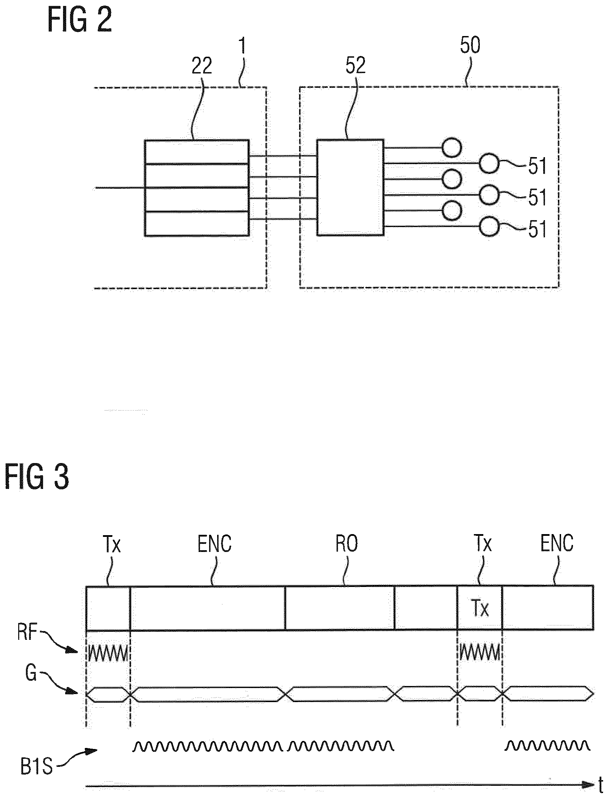

In Fig. 2 ist eine beispielshaften Ausführungsform einer Hochfrequenzeinheit 22 und Lokalspulenmatrix 50 zur Ausführung des Verfahrens. Die Hochfrequenzeinheit 22 weist mehrere Oszillatoren und Verstärker zur Erzeugung einer Mehrzahl an Hochfrequenzsignalen auf. Durch die separaten Oszillatoren sind Signale unterschiedlicher Frequenz und Phase unabhängig voneinander erzeugbar. Der separate Verstärker erlaubt dabei, auch die Amplitude unabhängig einzustellen. Im Folgenden wird ein Oszillator zusammen mit dem damit in Signalverbindung stehenden Verstärker als Sendekanal bezeichnet. Die Hochfrequenzeinheit 22 mit den Sendekanälen können auch zur Anregung der Kernspins, beispielsweise bei einem pTX-Magnetresonanztomographen eingesetzt werden.

Die von der Hochfrequenzeinheit 22 erzeugten Hochfrequenzsignale werden an eine Schaltmatrix 52 weitergeleitet. Die Schaltmatrix ist ausgelegt, eine Signalverbindung zwischen der Hochfrequenzeinheit 22 und einer Spulenwicklung 51 der Lokalspulenmatrix 50 herzustellen, sodass das Hochfrequenzsignal in ein magnetisches Hochfrequenz-Wechselfeld umgewandelt wird. Grundsätzlich ist es aber auch möglich, die Antennenspulen direkt mit der Hochfrequenzeinheit 22 zu verbinden, es besteht dann jedoch eine feste Zuordnung und die maximale Anzahl der nutzbaren Antennenspulen ist gleich der Anzahl der Kanäle.

Die Schaltmatrix 52 kann dabei einfache Schaltelemente aufweisen, die möglichst ohne Veränderung Signale von der Hochfrequenzeinheit 22 zu einer wählbaren Antennenspule bzw. Spulenwicklung 51 weiterleitet. Auf diese Weise kann die räumliche Verteilung des ausgesendeten Feldes verändert werden und mit den vorhandenen Kanälen ein Bereich aus einer Vielzahl von Spulen ausgewählt werden, ohne dass beispielsweise die Lokalspulenmatrix räumlich verschoben werden muss.

Es ist aber auch denkbar, dass die Schaltmatrix 52 einstellbare oder zuschaltbare Phasenschieber und/oder Addierglieder und/oder Dämpfer aufweist, die es erlauben, die Eingangssignale von der Hochfrequenzeinheit 22 zu unterschiedlichen neuen Signalen mit veränderbarer Phase und Amplitude zu kombinieren, wobei die Anzahl der erzeugten Signale und damit auch die Anzahl der mit einem Signal versorgbaren Antennenspulen größer als die Anzahl der Kanäle sein kann. Grundsätzlich ist es mit einer derartigen Schaltmatrix auch denkbar, eine Lokalspulenmatrix 50 mit mehreren Antennenspulen 51 mit Signalen aus einer Hochfrequenzeinheit mit einem Kanal zu versorgen, solange die Signale die gleiche Frequenz aufweisen. Eine derartige Schaltmatrix 52 erhöht vorteilhafter Weise die Flexibilität und die Einsatzmöglichkeiten des Erfindungsgemäßen Verfahrens, ohne die Kosten durch viele Kanäle in der Hochfrequenzeinheit in die Höhe zu treiben.

Die Schaltmatrix 52 kann dabei auch Teil der Hochfrequenzeinheit 22 sein, allerdings entfällt dann der Vorteil der geringeren Anzahl an Verbindungsleitungen zwischen Hochfrequenzeinheit 22 und Lokalspulenmatrix 50.

Mittels der Hochfrequenzeinheit 22, der Lokalspulenmatrix 50 oder der Körperspule 14 und gegebenen Falls der Schaltmatrix 52 lässt sich eine Vielzahl von räumlichen Verteilungen eines magnetischen Wechselfeldes einer Frequenz bzw. mehrerer Felder unterschiedlicher Frequenz für das nachfolgend dargestellte Verfahren erzeugen.

In Fig. 3 ist ein beispielhafter zeitlicher Ablauf einer Magnetresonanzmessung für eine Bilderfassung dargestellt. Die Zeitachse verläuft nach rechts. In der oberen Leiste sind die einzelnen Phasen einer Magnetresonanzmessung angegeben. Ein Messzyklus, auch als Pulse-Train bezeichnet, beginnt mit einer Anregung von Kernspins durch einen Anregungspuls, hier mit TX bezeichnet. Darauf folgt eine Phasenkodierung ENC zur Aufprägung einer räumlichen Orientierung auf die Kernspins. In der als Readout RO bezeichneten Phase werden die Magnetresonanzsignale empfangen und aufgezeichnet bzw. ausgewertet. Danach kann eine Pause folgen, in der beispielsweise die Kernspins relaxieren, bevor eine neue Anregung erfolgt.

In Fig. 3 sind von Oben nach Unten die Zeilen für verschiedene Signale angegeben. Mit RF ist das Hochfrequenzsignal bezeichnet, mit dem die Anregung erfolgt. G gibt die Gradientensignale der Gradientenspulen an. BIS bezeichnet schließlich das erfindungsgemäße Hochfrequenzsignal zur Korrektur einer BO-Inhomogenität an.

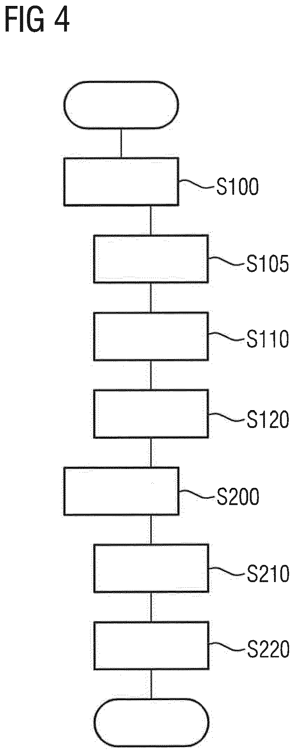

In Fig. 4 ist schließlich ein beispielhafter schematischer Ablaufplan einer Ausführungsform des erfindungsgemäßen Verfahrens dargestellt.

Das erfindungsgemäße Verfahren der Fig. 4 zur Korrektur einer BO-Inhomogenität gliedert sich in die beiden Hauptschritte S100 und S200. In Schritt S100 bei dem zunächst ein Sendesignal durch die Steuereinheit 20 ermittelt wird, das zur Korrektur der Auswirkung der Inhomogenität in einem Untersuchungsvolumen mittels des Bloch-Siegert-Effektes geeignet ist.

Dazu muss zunächst die BO-Inhomogenität bekannt sein. Dabei ist es denkbar, dass zunächst in Teilschritt S105 durch Messen eine BO-Map mit dem Magnetresonanztomographen 1 erfasst wird. Dazu können zum Beispiel zwei Magnetresonanztomographien erstellt werden, deren Magnetresonanzsignale bei unterschiedlichen Echozeiten gemessen wurden. Aus der BO-Map kann die Steuerung die BO-Inhomogenität in Schritt S110 ermitteln.

Es ist aber auch denkbar, dass die BO-Inhomogenität durch gespeicherte Werte aus der Lage und anderen Parametern des Patienten geschätzt werde. Die gespeicherten Werte beruhen dabei vorzugsweise auf einem physiologischen Modell oder Messwerten, die für den Patienten skaliert werden.

In einem Teilschritt S120 bestimmt die Steuereinheit eine Frequenzverteilung und eine räumliche Verteilung des Sendesignales, mit der gemäß Bloch-Siegert-Effekt die Wirkung der BO-Inhomogenität durch das Sendesignal zumindest teilweise in dem Untersuchungsvolumen kompensiert wird. Dabei ist es auch denkbar, dass die Frequenzverteilung derart ist, dass die Frequenz des Sendesignals überall konstant ist.

In diesem Fall ist die räumliche Amplitudenverteilung proportional zum Quadrat der BO-Inhomogenität und die Zielverteilung kann unmittelbar bestimmt werden. Ist die Frequenz zusätzlich variabel, so kann beispielsweise ein numerisches Optimierungsverfahren eingesetzt werden, dass die Abweichung der Larmorfrequenz zum Quadrat als Fehler verwendet und diesen durch Variation von Frequenz und Feldstärke minimiert. Randbedingungen sind dabei die zu S210 erläuterten Eigenschaften der Radiowellen und Spulenwicklungen 51 zum Aussenden.

Im einfachsten Fall ist es denkbar, dass eine Korrektur nur an einem einzelnen Punkt erforderlich ist und dafür eine einzige Frequenz und eine (homogene) Feldstärke bestimmt wird.

Anschließend muss in dem Hauptschritt S200 durch Aussenden die ermittelte Frequenz- und räumliche Verteilung umgesetzt werden. Dabei können zum Beispiel die bei der SAR-Bestimmung verwendeten Rechenverfahren angewendet werden.

Gemäß der Maxwellschen Gesetze und der Geometrie der Antennen bestimmt die Steuereinheit in Teilschritt S210 die den Antennen zuzuführenden Signale in Phase und Amplitude. Für unterschiedliche Frequenzen, sofern diese genutzt werden, kann dies jeweils separat erfolgen. Auch hier können wieder Optimierungsverfahren eingesetzt werden, die die Abweichung zwischen aufgrund der Elektrodynamik zu erwartender Verteilung und der vorher bestimmten Ziel-Verteilung minimiert. Daraus bestimmt die Steuereinheit 20 die Einstellungen bzw. Konfiguration der Hochfrequenzeinheit 22 und/oder der Antennenelemente, die die ermittelten Signale mit entsprechender Phase und Amplitude nachfolgend erzeugen und abstrahlen.

In einem Teilschritt S220 nimmt die Steuereinheit 22 die Einstellung Hochfrequenzeinheit 22 und/oder Antenne bzw. der Schaltmatrix vor und löst in einem Teilschritt S230 das Erzeugens des ermittelten Sendesignals in der Hochfrequenzeinheit 22 aus, sodass es gemäß der ermittelten Konfiguration von den Antennenelementen in das Untersuchungsvolumen abgestrahlt wird und dort wie vorgesehen die Larmorfrequenz korrigiert.

Wie der Fig. 4 zu entnehmen ist, gibt es Phasen bei einer Magnetresonanzmessung, die frei von anderen für die Magnetresonanztomographie erforderlichen Hochfrequenzsignalen sind. Insbesondere die Phase während der Kodierung durch die Gradienten ist besonders geeignet, das erfindungsgemäße Verfahren anzuwenden. Zu diesem Zeitpunkt wäre es auch möglich, eine gemeinsame Hochfrequenzeinheit 22 und Antenne für Anregungspuls und Sendesignal zur Korrektur zu verwenden, da die beiden Phasen nacheinander stattfinden.

Während des Anregungspulses besteht auch die Möglichkeit, die Inhomogenität allein durch eine Frequenzverbreiterung des Pulses auszugleichen.

Während des Readouts, d.h. dem Messen der Magnetresonanzsignale dürfen keine Signale auf der Larmorfrequenz den Empfang stören. Hier ist eine Korrektur gemäß dem Verfahren denkbar, indem die Empfänger entsprechende Eingangsfilter aufweisen, die das erfindungsgemäße Sendesignal zur Korrektur ausblenden bzw. unterdrücken, das ja eine Frequenz neben der idealen Larmorfrequenz aufweist.

Denkbar wäre auch ein intermittierendes Empfangen und dazwischen Senden des Sendesignals zur Korrektur. Dabei kann durch eine höhere Amplitude und /oder größere Frequenzabweichung des Sendesignals die Abweichung der Larmorfrequenz in den Sendepausen ausgeglichen werde, sodass im zeitlichen Mittel eine korrekte bzw. ideale Larmorfrequenz erzielt wird.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zur Korrektur einer BO-Inhomogenität bei einer Magnetresonanzmessung mit einem Magnetresonanztomographen (1), wobei die BO-Inhomogenität aus Erfahrungswerten abgeschätzt oder durch eine B0-Feldmessung mit dem Magnetresonanztomographen bestimmt wird, wobei der Magnetresonanztomograph (1) eine Steuereinheit (20) , eine Hochfrequenzeinheit (22) und eine Sendeantenne aufweist, wobei das Verfahren die Schritte aufweist: (S100) Ermitteln eines Sendesignales durch die Steuereinheit (20), welches zur Korrektur der Auswirkung der Magnetfeld-Inhomogenität in einem Untersuchungsvolumen mittels des Bloch-Siegert-Effektes geeignet ist; (S200) Aussenden des Sendesignals in das Untersuchungsvolumen.

2. Verfahren nach Anspruch 1, wobei der Schritt des Ermittelns des Sendesignales die Schritte aufweist:
(S110) Ermitteln einer BO-Inhomogenität in dem Untersuchungsvolumen durch den Magnetresonanztomographen (1);
(S120) Bestimmen einer Frequenzverteilung und einer räumlichen Verteilung des Sendesignales durch die Steuereinheit (20), mit der gemäß Bloch-Siegert-Effekt die Wirkung der BO-Inhomogenität durch das Sendesignal zumindest teilweise in dem Untersuchungsvolumen kompensiert wird.

3. Verfahren nach Anspruch 1 oder 2,
wobei die Sendeantenne eine Mehrzahl an Antennenelementen aufweist, wobei der Schritt (S200) des Aussendens die Schritte aufweist:
(S210) Bestimmen einer Konfiguration der Hochfrequenzeinheit (22) und/oder der Antennenelementen zur näherungsweisen Erzielung der gewünschten räumlichen Verteilung;
(S220) Einstellen der Hochfrequenzeinheit (22) und/oder Sendeantenne gemäß der Konfiguration;
(S230) Erzeugen des ermittelten Sendesignals mit der Hochfrequenzeinheit (22) und Senden über die Sendeantenne.

4. Verfahren nach einem der Ansprüche 2 oder 3, wobei das Verfahren weiterhin den Schritt aufweist:
(S105) Ermitteln einer BO-Map durch den Magnetresonanztomographen;
wobei in Schritt (S110) das Ermitteln einer BO-Inhomogenität in dem Untersuchungsvolumen durch den Magnetresonanztomographen anhand der BO-Map erfolgt.

5. Verfahren nach Anspruch 4, wobei iterativ das Ermitteln einer BO-Map unter Anwendung eines Verfahrens zur Korrektur nach einem der Ansprüche 1 bis 3 erfolgt.

6. Verfahren nach einem der vorhergehenden Ansprüche, wobei das Verfahren weiterhin die Schritte aufweist:
Bestimmen einer Frequenzverteilung und Leistung eines Anregungspulses, der unter der bestimmten BO-Inhomogenität eine homogene Anregung in dem Untersuchungsvolumen erzielt;
Aussenden des bestimmten Anregungspulses über eine Anregungsantenne.

7. Verfahren nach einem der vorhergehenden Ansprüche, wobei der Schritt (S200) des Aussendens während der Phasencodierung und/oder des Readouts erfolgt.

8. Verfahren nach einem der vorhergehenden Ansprüche, wobei in Schritt (S100) des Ermittelns des Sendesignals eine zeitliche Abhängigkeit der Frequenz und/oder Amplitude derart bestimmt wird, dass durch das ausgesendete Sendesignal über die Dauer der Magnetresonanzmessung die Larmorfrequenz im zeitlichen Mittel im Wesentlichen korrigiert wird.

9. Magnetresonanztomograph, wobei der Magnetresonanztomograph (1) eine Steuereinheit (20), eine Hochfrequenzeinheit (22) und eine Sendeantenne aufweist, wobei der Magnetresonanztomograph (1) ausgelegt ist, das Verfahren nach einem der Ansprüche 1 bis 8 auszuführen.

10. Magnetresonanztomograph nach Anspruch 9, wobei die Sendeantenne ein Array aus Antennenelementen aufweist.

11. Computerprogrammprodukt, welches direkt in einen Prozessor einer Steuereinheit (20) eines Magnetresonanztomographen (1) ladbar ist, mit Programmcode-Mitteln, um alle Schritte eines Verfahrens nach einem der Ansprüche 1 bis 8 auszuführen, wenn das Programmprodukt auf der Steuereinheit (20) ausgeführt wird.

12. Computerlesbares Speichermedium mit darauf gespeicherten elektronisch lesbaren Steuerinformationen, welche derart ausgestaltet sind, dass sie bei Verwendung des Speichermediums in der Steuereinheit (20) eines Magnetresonanztomographen (1) das Verfahren nach einem der Ansprüche 1 bis 8 durchführen.

## Claims

1. Method for correcting a B0 inhomogeneity in a magnetic resonance scan with a magnetic resonance tomograph (1), wherein the B0 inhomogeneity is estimated from empirical values or is determined by a B0 field measurement with the magnetic resonance tomograph,
wherein the magnetic resonance tomograph (1) comprises a control unit (20), a radio frequency unit (22) and a transmitting antenna, wherein the method comprises the steps:
(S100) determination of a transmission signal by the control unit (20) which is suitable for correcting the effect of the magnetic field inhomogeneity in an examination volume by means of the Bloch-Siegert effect;
(S200) emitting the transmission signal into the examination volume.

2. Method according to claim 1, wherein the step of determining the transmission signal comprises the steps:
(S110) determining a B0 inhomogeneity in the examination volume by means of the magnetic resonance tomograph (1);
(S120) determining a frequency distribution and a spatial distribution of the transmission signal by means of the control unit (20) with which according to the Bloch-Siegert effect, the effect of the B0 inhomogeneity is at least partially compensated for in the examination volume by the transmission signal.

3. Method according to claim 1 or 2,
wherein the transmitting antenna has a plurality of antenna elements, wherein the step (S200) of transmission has the steps:
(S210) determining a configuration of the radio frequency unit (22) and/or the antenna elements for approximate achievement of the desired spatial distribution;
(S220) setting the radio frequency unit (22) and/or transmitting antenna according to the configuration;
(S230) generating the determined transmission signal with the radio frequency unit (22) and transmitting by means of the transmitting antenna.

4. Method according to one of claims 2 or 3, wherein the method further comprises the step:
(S105) determining a B0 map by means of the magnetic resonance tomograph;
wherein, in step (S110), the determination of a B0 inhomogeneity in the examination volume by the magnetic resonance tomograph takes place on the basis of the B0 map.

5. Method according to claim 4, wherein the determination of a B0 map takes place iteratively using a method for correction according to one of claims 1 to 3.

6. Method according to one of the preceding claims, wherein the method further comprises the steps:
determining a frequency distribution and power of an excitation pulse which, under the determined B0 inhomogeneity, achieves a homogeneous excitation in the examination volume;
emitting the determined excitation pulse by means of the excitation antenna.

7. Method according to one of the preceding claims, wherein the step (S200) of emitting takes place during the phase encoding and/or the readout.

8. Method according to one of the preceding claims, wherein, in the step (S100) of the determination of the transmission signal, a temporal dependency of the frequency and/or amplitude is determined such that by means of the emitted transmission signal over the duration of the magnetic resonance scan, the Larmor frequency is substantially corrected as an average over time.

9. Magnetic resonance tomograph, wherein the magnetic resonance tomograph (1) comprises a control unit (20), a radio frequency unit (22) and a transmitting antenna, wherein the magnetic resonance tomograph (1) is configured to carry out the method according to one of claims 1 to 8.

10. Magnetic resonance tomograph according to claim 9, wherein the transmitting antenna comprises an array of antenna elements.

11. A computer program product which is loadable directly into a processor of a control system (20) of a magnetic resonance tomograph (1), having program code means in order to carry out all the steps of a method according to one of claims 1 to 8 when the program product is executed on the control unit (20).

12. A computer readable storage medium with items of electronically readable control information stored thereon, which are configured in order, on use of the storage medium in the control unit (20) of a magnetic resonance tomograph (1), to carry out the method according to one of claims 1 to 8.

## Revendications

1. Procédé de correction d'une inhomogénéité BO dans une mesure de résonnance magnétique par un tomodensitomètre (1) à résonnance magnétique, dans lequel on évalue l'inhomogénéité BO à partir de valeurs d'expérience ou on la détermine par une mesure de champ BO avec le tomodensitomètre à résonnance magnétique,
dans lequel le tomodensitomètre (1) à résonnance magnétique a une unité (20) de commande, une unité (22) de haute fréquence et une antenne d'émission, dans lequel le procédé a les stades :
(S100) détermination d'un signal d'émission par l'unité (20) de commande, qui est propre à corriger l'effet de l'inhomogénéité du champ magnétique dans un volume à examiner au moyen de l'effet Bloch-Siegert ;
(S200) envoi du signal d'émission dans le volume à examiner.

2. Procédé suivant la revendication 1, dans lequel le stade de la détermination du signal d'émission comprend les stades :
(S110) détermination par le tomodensitomètre (1) à résonnance magnétique d'une inhomogénéité BO dans le volume à examiner ;
(S120) détermination d'une distribution fréquentielle et d'une distribution spatiale du signal d'émission par l'unité (20) de commande, par laquelle on compense au moins en partie dans le volume à examiner par le signal d'émission suivant l'effet Bloch-Siegert l'effet de l'inhomogénéité B0.

3. Procédé suivant la quelconque revendication 1 ou 2, dans lequel l'antenne d'émission à une pluralité d'éléments d'antenne, dans lequel le stade (S200) de l'envoi comprend les stades :
(S210) détermination d'une configuration de l'unité (22) de haute fréquence et/ou des éléments d'antenne pour atteindre de manière approximative la distribution spatiale souhaitée ;
(S220) réglage de l'unité (22) et/ou de l'antenne d'émission suivant la configuration ;
(S230) production du signal d'émission déterminé par l'unité (22) de haute fréquence et envoi par l'antenne d'émission.

4. Procédé suivant l'une quelconque des revendications 2 ou 3, dans lequel le procédé comprend en outre le stade :
(S105) détermination d'une carte BO par le tomodensitomètre à résonnance magnétique ;
dans lequel, dans le stade (S110), la détermination d'une inhomogénéité BO dans le volume à examiner s'effectue à l'aide de la carte BO par le tomodensitomètre à résonnance magnétique.

5. Procédé suivant la revendication 4, dans lequel la détermination itérativement d'une carte BO s'effectue en utilisant un procédé de correction suivant l'une des revendications 1 à 3.

6. Procédé suivant l'une quelconque des revendications précédentes, dans lequel le procédé comprend en outre les stades :
détermination d'une distribution fréquentielle et d'une puissance d'une impulsion d'excitation qui, sous l'inhomogénéité BO déterminée, atteint une excitation homogène dans le volume à examiner ;
envoi de l'impulsion d'excitation déterminée par l'intermédiaire d'une antenne d'excitation.

7. Procédé suivant l'une quelconque des revendications précédentes, dans lequel le stade (S200) de l'envoi s'effectue pendant le codage de phase et/ou le readout.

8. Procédé suivant l'une quelconque des revendications précédentes, dans lequel dans le stade (S110) de la détermination du signal d'émission on détermine une variation de la fréquence et/ou de l'amplitude en fonction du temps, de manière à corriger sensiblement, par le signal d'émission envoyé par le biais de la durée de la mesure de résonnance magnétique, la fréquence de Larmor en moyenne dans le temps.

9. Tomodensitomètre à résonnance magnétique dans lequel le tomodensitomètre (1) à résonnance magnétique a une unité (20) de commande, une unité (22) de haute fréquence et une antenne d'émission, dans lequel le tomodensitomètre (1) à résonnance magnétique est conçu pour effectuer le procédé suivant l'une quelconque des revendications 1 à 8.

10. Tomodensitomètre à résonnance magnétique suivant la revendication 9, dans lequel l'antenne d'émission a un réseau d'éléments d'antenne.

11. Produit de programme d'ordinateur, qui peut être chargé directement dans un processeur d'une unité (20) de commande d'un tomodensitomètre (1) à résonnance magnétique, comprenant des moyens de code de programme pour effectuer tous les stades d'un procédé suivant l'une des revendications 1 à 8, lorsque le produit d'un programme est réalisé sur l'unité (20) de commande.

12. Support de mémoire déchiffrable par ordinateur, sur lequel sont mises en mémoire des informations de commande déchiffrables électroniquement, qui sont conformées de manière à ce qu'elles effectuent, lors de l'utilisation du support de mémoire dans l'unité (20) de commande d'un tomodensitomètre (1) à résonnance magnétique, le procédé suivant l'une quelconque des revendications 1 à 8.
